# EUROPEAN PATENT APPLICATION

(11) **EP 2 325 868 A1**
(43) Date of publication of application: **25.05.2011**
(21) Application number: 09814212.8
(22) Date of filing: 04.08.2009
(51) Int. Cl.: H01L 21/02, H01L 27/12

(54) **METHOD FOR MANUFACTURING LAMINATED WAFER**

(30) Priority: 19.09.2008 JP 2008241378
(71) Applicant: Shin-Etsu Handotai Co., Ltd., Tokyo 100-0004 (JP)
(72) Inventor: KOBAYASHI, Norihiro, Annaka-shi Gunma 379-0125 (JP); AGA, Hiroji, Annaka-shi Gunma 379-0125 (JP); ISHIZUKA, Tohru, Annaka-shi Gunma 379-0125 (JP)
(74) Representative: Wibbelmann, Jobst
(86) International application number: PCT/JP2009/003708
(87) International publication number: WO 2010/032366

(57) **Abstract**

According to the present invention, there is provided a method for manufacturing a bonded wafer, comprising: forming an ion implanted layer in a bond wafer; bonding an ion implanted surface of the bond wafer to a surface of a base wafer directly or through a silicon oxide film; and performing a delamination heat treatment, wherein, after the formation of the ion implanted layer and before the bonding, a plasma treatment is carried out with respect to a bonding surface of at least one of the bond wafer and the base wafer, and the delamination heat treatment is carried out at a fixed temperature by directly putting the bonded wafer into a heat-treating furnace whose furnace temperature is set to the fixed temperature less than 475°C without a temperature increasing step. As a result, it is possible to provide the method for manufacturing a bonded wafer that can avoid defects that are generated on a thin film or a bonding interface of the bonded wafer when bonding the bond wafer consisting of the silicon single crystal to the base wafer directly or through the silicon oxide film that is as very thin as 100 nm or below.

## Description

### TECHNICAL FIELD

The present invention relates to a method for manufacturing a bonded wafer by using an ion implantation and delamination method, and typically to a method for manufacturing a bonded wafer by bonding a wafer having, e.g., hydrogen ions implanted therein to the other wafer and then delaminating the ion implanted wafer at an ion implanted layer.

### BACKGROUND ART

When manufacturing a bonded SOI wafer based on the ion implantation and delamination method, processing such as formation of an insulator film, hydrogen ion implantation, bonding, and a delamination heat treatment is required. The SOI wafer subjected to the delamination heat treatment has a problem that is generation of a defect on a bonding interface called a void or a blister. This defect is strongly dependent on a preprocess including the delamination heat treatment. As one of causes of this problem, there is a particle that adheres during each process. In particular, the defect tends to be frequently produced as a thickness of a buried oxide film (BOX) is reduced.
When fabricating the SOI wafer, the number of defects tends to increase when a thickness of the BOX is reduced to 100 nm or below, and the defects are produced due to, e.g., particles in a preprocess including the delamination heat treatment even when the BOX has a large thickness of 100 nm or above.

As these defects, there are a blister and a void that can be found by visual observation of a delamination surface (an SOI surface), an LPD (Light Point Defect) that is detected by a particle counter, and others. However, the LPD is actually a small void when observed by using, e.g., an SEM. These defects must be reduced or eliminated as much as possible, and defects of an SOI wafer having a thin BOX or a directly bonded wafer having no BOX on which defects are apt to be produced must be decreased.

To reduce the defects, there is a method for increasing a hydrogen ion implantation depth and thereby increasing a thickness of an SOI layer to improve rigidity, but its effect is not sufficient when a thickness of the BOX is decreased. Further, when hydrogen ions are deeply implanted, an amount of reducing a thickness of the SOI layer based on, e.g., sacrificial oxidation in a postprocess is increased, and hence a process time is prolonged, which results in a tendency that an SOI film thickness distribution is deteriorated.

Furthermore, as another method for reducing the defects, there is a method for carrying out a plasma treatment of exposing a bonding surface to plasma to activate the bonding surface, thereby improving bonding strength. For example, Patent Document 1 discloses a method for carrying out a plasma treatment to form an oxide film, cleaning its surface with pure water, and drying and bonding the same (see Patent Document 1).

However, a reduction in defects (voids or blisters) on the bonding interface is not sufficient even though such methods are utilized to manufacture the bonded wafer.

In particular, when a silicon oxide film provided on the bonding surface has a thickness of 100 nm or below or when direct bonding is performed without interposing the oxide film, a reduction in defects (voids or blisters) on the bonding interface is difficult. Thus, a method for temporarily forming an oxide film having a thickness exceeding 100 nm to effect bonding, reducing a film thickness of a bond wafer, then carrying out a high-temperature heat treatment in an inert gas atmosphere to decrease a thickness of the silicon oxide film (a buried oxide film (BOX)) is used in some cases (see Patent Document 2).

### CITATION LIST

Patent Document 1: Japanese Patent Application Laid-open No. 5-82404 (1993)
Patent Document 2: Japanese Patent Application Laid-open No. 2004-221198

### DISCLOSURE OF INVENTION

Therefore, in view of the above-described problem, it is an object of the present invention to provide a method for manufacturing a bonded wafer that can prevent defects from being generated on a thin film or a bonding interface of the bonded wafer when bonding a bond wafer consisting of a silicon single crystal to a base wafer directly or through a silicon oxide film that is as thin as 100 nm or below.

To achieve this object, according to the present invention, there is provided a method for manufacturing a bonded wafer, comprising at least: implanting at least one type of gas ion selected from a hydrogen ion and a rare gas ion from a surface of a bond wafer consisting of a silicon single crystal to form an ion implanted layer in the bond wafer; bonding an ion implanted surface of the bond wafer to a surface of a base wafer directly or through a silicon oxide film; and then performing a delamination heat treatment to delaminate the bond wafer at the ion implanted layer, thereby manufacturing the bonded wafer, wherein, after the formation of the ion implanted layer and before the bonding, a plasma treatment is carried out with respect to a bonding surface of at least one of the bond wafer and the base wafer, and the delamination heat treatment is carried out at a fixed temperature by directly putting the wafer after the bonding into a heat-treating furnace whose furnace temperature is set to the fixed temperature less than 475°C without a temperature increasing step.

The present invention is mainly characterized in that performing the plasma treatment with respect to the wafer surface before bonding is combined with the delamination heat treatment at a fixed temperature that is less than 475°C without the temperature increasing step.
When the plasma treatment is performed with respect to at least one of the wafers before bonding at the time of bonding the wafers directly or though the silicon oxide film, the bonding strength is increased. Moreover, when the delamination heat treatment is performed at the fixed temperature without the temperature increasing step, bonding strength is precipitously increased and growth of defects, which can be a cause of voids, can be suppressed (annihilated). Additionally, at the time of the delamination heat treatment, since voids are apt to be generated all the more when the temperature is set to 475°C or above, the delamination heat treatment temperature is set to be less than 475°C. As a result, the voids can be suppressed from being produced on the bonding interface, whereby generation of the defects on the thin film or the bonding interface of the bonded wafer can be prevented.

Further, it is preferable to set the fixed temperature of the delamination heat treatment to the range of 400°C to 450°C.
When the temperature of the delamination heat treatment is less than 400°C, a long time that is not less than several-ten hours is required or external force must be applied to the ion implanted layer to effect delamination, and hence the efficiency is lowered.
Furthermore, if the temperature range of 450°C or below is adopted, a void generation ratio is not precipitously increased, whereby setting an upper limit temperature to 450°C or below enables assuredly suppressing generation of voids.

Moreover, it is preferable to set a temperature when taking out the bonded wafer from the heat-treating furnace after carrying out the heat treatment at the fixed temperature to be equal to the temperature in the delamination heat treatment.
After carrying out the heat treatment at the fixed temperature, delamination has already occurred in the wafer after the bonding, and the temperature at the time of taking out from the heat-treating furnace is not restricted in particular. However, when this temperature is equal to the temperature of the delamination heat treatment, a temperature decreasing step can be omitted, which is efficient, thereby reducing a manufacturing cost.

Additionally, it is preferable to set a thickness of the silicon oxide film to 100 nm or below.
As described above, according to the method for manufacturing a bonded wafer of the present invention, generation of defects on a thin film side of the bonded wafer can be suppressed, and voids or blisters can be prevented from being produced on a bonding interface even when a thickness of a silicon oxide film is as small as 100 nm or below.

As described above, in case of the conventionally performed delamination heat treatment having the temperature increasing step, although the bonding strength is increased during temperature elevation, defects on the interface, which can be a cause of voids, also grow, and hence the voids cannot be reduced. However, like the present invention, when the delamination heat treatment at the fixed temperature is carried out without the temperature increasing step in addition to the plasma activation processing for the bonding surface, this processing functions to suppress (annihilate) the growth of the defects which can be a cause of voids with a precipitous increase in bonding strength, thereby sufficiently decreasing the voids or the blisters on the bonding surface.
Furthermore, when the fixed temperature of the delamination heat treatment is set to be less than 475°C, it is possible to suppress a temperature rise at the time of putting the wafer into the heat-treating furnace that increases a temperature distribution within the wafer, and delamination can be prevented from gradually occurring within the wafer.
Moreover, these effects can suppress generation of defects on the thin film or the bonding interface of the bonded wafer.

### BRIEF DESCRIPTION OF DRAWING(S)

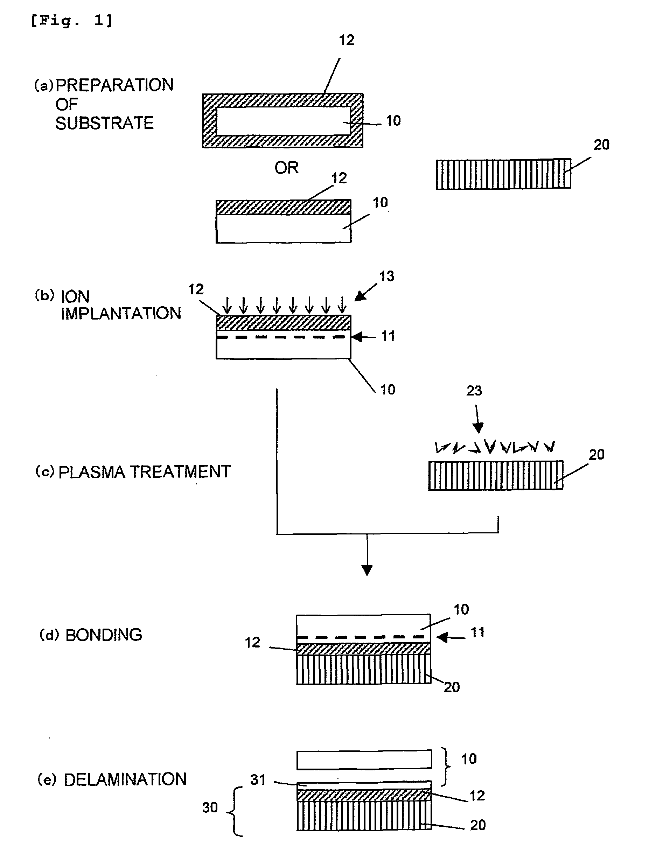

FIG. 1 is a flowchart showing an example of steps in a method for manufacturing a bonded wafer according to the present invention.

### BEST MODE(S) FOR CARRYING OUT THE INVENTION

The present invention will now be more specifically explained hereinafter.
As described above, there has been waited development of a method for manufacturing a bonded wafer, the method being configured to prevent defects from being generated on a thin film and a bonding interface of the bonded wafer when bonding a bond wafer consisting of a silicon single crystal to a base wafer directly or through a silicon oxide film that is as very thin as 100 nm or below.

Usually, when performing a delamination heat treatment in an ion implantation and delamination method, as described in, e.g., Japanese Patent Application Laid-open No. 2003-347526, there is carried out a method of putting a wafer after bonding into a heat-treating furnace maintained at a low temperature of approximately 350°C, increasing the temperature to 500°C or above, and holding the wafer for a predetermined time.
However, in case of bonding a silicon single crystal wafer directly or through a silicon oxide film of 100 nm or below even though bonding strength is increased by performing a plasma treatment to at least one of the wafers before bonding, voids or blisters cannot be sufficiently reduced when a heat treatment having such a temperature increasing step is carried out.

Thus, as a result of repeating keen examinations, the present inventors found that growth of defects that can be a cause of voids can be suppressed (annihilated) with a precipitous increase in bonding strength by performing a plasma treatment with respect to a bonding surface of a wafer before bonding to increase bonding strength, carrying out a delamination heat treatment having an annealing temperature equal to an input temperature of the wafer after the bonding, and setting this temperature to 475°C or below, thereby bringing the present invention to completion.

Although the present invention will be described hereinafter in detail with reference to the drawing, the present invention is not restricted thereto. FIG. 1 is a flowchart showing an example of steps in a method for manufacturing a bonded wafer according to the present invention.

First, at a step (a) in FIG. 1, for example, two mirror-polished silicon single crystal wafers are prepared as a bond wafer 10 and base wafer 20.
Here, an oxide film 12 is previously formed as an insulator film on the bond wafer 10 alone in FIG. 1, but the oxide film 12 may be formed on the base wafer 20 alone or may be formed on both the wafers. Further, both the wafers may have no oxide film formed thereon, and they may be directly bonded to each other. These conformations are appropriately selected in accordance with purposes.
As the oxide film formed at this time, for example, a thermal oxide film or a CVD oxide film can be formed. It is to be noted that the oxide film that is to be formed on each wafer may be formed on an entire surface of the wafer including a back surface or may be formed on a bonding surface alone.

Furthermore, a thickness of the oxide film to be formed may be set to 100 nm or below.
Since the method for manufacturing a bonded wafer according to the present invention can suppress generation of voids or blisters on a bonding interface, even if a thickness of the silicon oxide film on the bonding surface is as thin as 100 nm or below and defects are apt to be generated, defects can be suppressed from being produced on a thin film or the bonding interface of the bonded wafer, which is preferable. It is to be noted that, when manufacturing an SOI wafer, it is desirable to set a lower limit of the oxide film to 5 nm because insulation properties may not be possibly maintained.

Then, at a step (b), at least one type of gas ions, i.e., hydrogen ions or rare gas ions are implanted from a surface (a bonding surface 13) of the oxide film 12 of the bond wafer 10 to form an ion implanted layer 11 in the wafer. At this time, other ion implantation conditions such as implantation energy, an implantation dose, and an implantation temperature can be appropriately selected so that a thin film having a predetermined thickness can be obtained.

At a step (c), a plasma treatment is carried out with respect to a bonding surface 23 of the base wafer 20 to provide a plasma-treated surface.
Here, the plasma treatment may be performed with respect to the oxide film 12 on the bond wafer 10 alone, or the plasma treatment may be carried out with respect to both the wafers. When directly bonding the wafers without interposing the oxide film, the plasma treatment may be carried out with respect to the bonding surface of one of the bond wafer and the base wafer alone, or the treatment may be effected with respect to the bonding surfaces of both the wafers.
When the plasma treatment is performed in this manner, for example, OH groups are increased to activate each processed surface, and the wafers can be strongly bonded based on hydrogen bonding and the like at the time of bonding.

At a step (d), the bonding surface 13 of the bond wafer 10 and the bonding surface 23 of the base wafer 20 are closely attached and bonded to each other.
In this manner, when the surfaces subjected to the plasma treatment are used as the bonding surfaces and both the wafers are closely attached to each other under, e.g., a reduced pressure or an ordinary pressure, bonding can be sufficiently strongly achieved without effecting a high-temperature treatment and others.

At a step (e), the bond wafer 10 is delaminated at the ion implanted layer 11 to fabricate a bonded wafer 30 having a thin film 31 formed on the base wafer 20 through the oxide film 12.
This delamination of the bond wafer is performed based on a heat treatment.
The wafer after the bonding is directly put into a heat-treating furnace having a furnace temperature set to a fixed temperature that is less than 475°C without a temperature increasing step, and this heat treatment is carried out at the fixed temperature.
Although bonding strength increases during a temperature rise when the furnace temperature is increased to gradually raise a wafer temperature during the heat treatment, defects on the bonding interface simultaneously grow with this increase, and hence a reduction in defects cannot be achieved. However, when a temperature of the wafer after the bonding is increased at a stretch to a delamination heat treatment temperature without a temperature increasing step, the growth of defects on the bonding interface can be suppressed, and the bonding strength can be increased.
Additionally, when the furnace temperature is set to 475°C or above, since the temperature is high, a temperature distribution is produced within the wafer, whereby the delamination gradually occurs within the wafer to facilitate generation of voids. Therefore, a furnace set temperature is determined to be less than 475°C. Although a lower limit of the furnace set temperature is not restricted in particular, setting a temperature higher than 350°C is preferable for occurrence of the delamination based on the heat treatment alone.

Here, the fixed heat treatment temperature of this delamination heat treatment can be set to fall within the range of 4.00°C to 450°C.
When the heat treatment temperature is less than 400°C, a heat treatment for several-tens hours or more is required to effect delamination, or mechanical external force must be applied to the ion implanted layer, which is not efficient, and hence setting this temperature to 400°C or above is preferable for manufacturing the wafer at a low cost.
Additionally, when the heat treatment temperature exceeds 450°C, since a void generation probability may increase, setting this temperature to 450°C or below is preferable, and generation of voids can be assuredly suppressed under this condition.

Further, after the delamination heat treatment, the bonded wafer can be taken out from the heat-treating furnace without a temperature decreasing step while maintaining the temperature in the delamination heat treatment.
A temperature when taking out the bonded wafer after the delamination heat treatment is arbitrary, and it is not restricted in particular, but the temperature does not have to be reduced if it is equal to the temperature in the delamination heat treatment, and the heat treatment step can be simplified, thereby reducing a manufacturing cost.

As described above, according to the present invention, it is possible to manufacture the bonded wafer including the thin film and the bonding interface having almost no defect formed thereon.

### EXAMPLE

The present invention will now be more specifically explained hereinafter based on an example and comparative examples, but the present invention is not restricted thereto.

### (Example 1)

A plurality of bond wafers and base wafers each consisting of a silicon single crystal having a diameter of 300 mm were prepared, and a silicon oxide film having a thickness of 20 nm was grown on each bond wafer alone based on dry oxidation at 950°C.
Then, hydrogen ions were implanted into one surface of the bond wafer through the silicon oxide film. Implantation conditions were 50 keV and 5×10¹⁶ atoms/cm².

Further, a nitrogen plasma treatment (a room temperature, a gas flow volume of 115 sccm, a pressure of 0.4 Torr (53.3 Pa), an output of 100 W, and 15 seconds) was performed with respect to each base wafer that is to be bonded to the bond wafer. Thereafter, the bond wafer and the base wafer were cleaned, and they were bonded to each other at a room temperature.

Subsequently, as a delamination heat treatment, each bonded wafer was directly put into a heat-treating furnace set to 400°C or 450°C (without a temperature increasing step) separately, a heat treatment time was set to 6 hours or 3 hours to effect a heat treatment, thereby delaminating each bond wafer. A temperature when taking out each wafer from the heat-treating furnace was set to be equal to the heat treatment temperature.
Additionally, defects on an SOI surface (a thin film) of each bonded SOI wafer after delamination were visually observed. Table 1 shows a result of this observation.

### (Comparative Example 1)

Each SOI wafer was fabricated under the same conditions as those in Example 1 except that a delamination heat treatment temperature was set to 475°C, 500°C, 550°C, or 600°C and a heat treatment time was set to 1 hour, 30 minutes, 30 minutes, or 30 minutes, and a state of each SOI surface (a thin film) was likewise visually observed. Table 1 also shows a result of this observation.

**[Table 1]**

| | EXAMPLE 1 | | COMPARATIVE EXAMPLE 1 | | | |
|---|---|---|---|---|---|---|
| HEAT TREATMENT TEMPERATURE | 400°C | 450°C | 475°C | 500°C | 550°C | 600°C |
| HEAT TREATMENT TIME | 6 HOURS | 3 HOURS | 1 HOUR | 30 MINUTES | 30 MINUTES | 30 MINUTES |
| VOID GENERATION RATIO | 20% | 0% | 100% | 100% | 100% | 100% |

As a result of visually observing defects on the SOI surface of each bonded SOI wafer after delamination according to Example 1, a void generation ratio (the number of SOI wafers having one or more voids produced thereon/the total number of SOI wafers) was 20% in case of 400°C and 0% in case of 450°C.
On the other hand, in the bonded wafers according to Comparative Example 1, defects were produced on all the SOI wafer surfaces. Further, when the defects were observed by using a microscope, it was found that voids were continuously formed to have linear shape, and the number of the produced defects was increased as the heat treatment temperature was raised.

### (Comparative Example 2)

Each SOI wafer was fabricated under the same conditions as those in Example 1 except that a heat treatment having a temperature increasing step (each wafer is put into a heat-treating furnace having a temperature of 350°C, held until the wafer reaches 350°C, and then subjected to the heat treatment at a heat treatment temperature of 400°C, 450°C, 500°C, 550°C, or 600°C for a heat treatment time of 6 hours, 3 hours, 30 minutes, 30 minutes, or 30 minutes through the temperature increasing step of 5°C/minute) was carried out as the delamination heat treatment, and each SOI surface was visually observed.

### (Comparative Example 3)

Each SOI wafer was fabricated under the same conditions as those in Example 1 except that a heat treatment having a temperature increasing step (each wafer is put into a heat-treating furnace having a temperature of 350°C and immediately subjected to the heat treatment at a heat treatment temperature of 400°C, 450°C, 500°C, 550°C, or 600°C for a heat treatment time of 6 hours, 3 hours, 30 minutes, 30 minutes, or 30 minutes through the temperature increasing step of 5°C/minute) was carried out as the delamination heat treatment, and each SOI surface was visually observed.
Table 2 shows results of Comparative Example 2 and Comparative Example 3.

**[Table 2]**

| HEAT TREATMENT TEMPERATURE | 400°C | 450°C | 500°C | 550°C | 600°C |
|---|---|---|---|---|---|
| HEAT TREATMENT TIME | 6 HOURS | 3 HOURS | 30 MINUTES | 30 MINUTES | 30 MINUTES |
| VOID GENERATION RATIO UNDER CONDITIONS IN COMPARATIVE EXAMPLE 2 | 60% | 40% | 60% | 40% | 60% |
| VOID GENERATION RATIO UNDER CONDITIONS IN COMPARATIVE EXAMPLE 3 | 60% | 40% | 40% | 40% | 80% |

As shown in Table 2, many bonded wafers according to Comparative Examples 2 and 3 have defects produced thereon, and it was revealed that generation of voids or blisters cannot be suppressed when the temperature increasing step is provided even though the delamination heat treatment temperature is less than 475°C and defects are thereby apt to be generated on the thin film of each bonded wafer.

It is to be noted that the present invention is not restricted to the foregoing embodiment. The foregoing embodiment is just an exemplification, and any examples that have substantially the same configuration and exercise the same functions and effects as the technical concept described in claims according to the present invention are included in the technical scope of the invention.

## Claims

1. A method for manufacturing a bonded wafer, comprising at least: implanting at least one type of gas ion selected from a hydrogen ion and a rare gas ion from a surface of a bond wafer consisting of a silicon single crystal to form an ion implanted layer in the bond wafer; bonding an ion implanted surface of a bond wafer to a surface of a base wafer directly or through a silicon oxide film; and then performing a delamination heat treatment to delaminate the bond wafer at the ion implanted layer, thereby manufacturing the bonded wafer,
wherein, after the formation of the ion implanted layer and before the bonding, a plasma treatment is carried out with respect to a bonding surface of at least one of the bond wafer and the base wafer, and
the delamination heat treatment is carried out at a fixed temperature by directly putting the wafer after the bonding into a heat-treating furnace whose furnace temperature is set to the fixed temperature less than 475°C without a temperature increasing step.

2. The method for manufacturing a bonded wafer according to claim 1, wherein the fixed temperature of the delamination heat treatment is set to the range of 400°C to 450°C.

3. The method for manufacturing a bonded wafer according to claim 1 or 2, wherein a temperature when taking out the bonded wafer from the heat-treating furnace after carrying out the heat treatment at the fixed temperature is set to be equal to the temperature in the delamination heat treatment.

4. The method for manufacturing a bonded wafer according to any one of claims 1 to 3, wherein a thickness of the silicon oxide film is set to 100 nm or below.
